# EUROPEAN PATENT APPLICATION

(11) **EP 4 669 050 A1**
(43) Date of publication of application: **24.12.2025**
(21) Application number: 25183756.3
(22) Date of filing: 18.06.2025
(51) Int. Cl.: H10D 1/68

(54) **COMPOSITE INSULATOR FILMS WITH LOW ELECTRICAL LEAKAGE & HIGH CHARGE CAPACITANCE**

(30) Priority: 18.06.2024 US 202418747212
(71) Applicant: Intel Corporation, Santa Clara, CA 95054 (US)
(72) Inventor: CHANG, Sou-Chi, Portland, 97229 (US); LIN, Chia-Ching, Portland, 97229 (US); AVCI, Uygar E., Portland, 97225 (US); OGUZ, Kaan, Portland, 97229 (US); LEE, Sudarat, Beaverton, 97005 (US); TUNG, I-Cheng, Hillsboro, 97124 (US); JEZEWSKI, Christopher J., Portland, 97229 (US)
(74) Representative: 2SPL Patentanwälte PartG mbB

(57) **Abstract**

Capacitor structures with a composite insulator comprising a first insulator and a second insulator. At least the first insulator is a compound of one or more metals and oxygen that may be deposited with an atomic layer deposition process upon topography having a high aspect ratio. Following a thermal anneal of the first insulator, the first insulator may be highly crystalline, but comprise a plurality of cracks where the first insulator is some lesser thickness. The second insulator may be deposited with an atomic layer deposition process to fill-in the cracks. Overburden associated with deposition of the second insulator may be removed and an electrode may then be formed over the resulting composite insulator.

## Description

### BACKGROUND

Advanced integrated circuit (IC) devices rely on robust high-performance capacitors. Such capacitors may take the form of metal-insulator-metal (MIM) capacitors or metal-insulator/oxide semiconductor (MIS/MOS) capacitors, which may be employed within a field effect transistor (FET), for example. High capacitance and low leakage MIMs are important in modern integrated circuits for power delivery or embedded DRAM. A number of insulator compositions of high relative permittivity and high dielectric response are attractive for capacitors offering high capacitance and low electrical leakage per unit area. Physical vapor deposition (PVD) is often employed to form thin films with such insulator compositions because PVD processes can provide, at low deposition temperatures, a highly crystalized thin film that achieves a high dielectric or charge response. However, PVD techniques are unable to fill high aspect ratio structures that are advantageous for capacitor architectures offering highest capacitance.

Although atomic layer deposition (ALD) techniques are able to fill high aspect-ratio structures, such processes often rely on high temperature anneals to achieve a film with a highly crystalized phase that is needed for the high-k dielectric (or charge storage) response. Unfortunately, many ALD insulator thin films suffer high electrical leakage following a thermal anneal. Accordingly, high density architectures, and associated fabrication techniques, offering both high charge capacitance and low electrical leakage are commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a flow diagram illustrating methods of forming a composite insulator, in accordance with some embodiments;
FIG. 2A and 2B are cross-sectional and plan views illustrating a MIM capacitor structure evolving during a fabrication process, in accordance with some embodiments;
FIG. 3 is a cross-sectional view of a MIM capacitor structure that would display high levels of electrical leakage;
FIG. 4A, 4B and 4C are cross-sectional and plan views illustrating a MIM capacitor structure further evolving during a fabrication process, in accordance with some embodiments;
FIG. 5 is a flow diagram illustrating methods of forming a high-density MIM capacitor structure, in accordance with some embodiments;
FIG. 6 is a cross-sectional view depicting a starting substrate suitable for the practice of the methods illustrated in FIG. 5, in accordance with some embodiments;
FIG. 7A is a cross-sectional view depicting a formation of a high-density structure in the substrate illustrated in FIG. 6, in accordance with some embodiments;
FIG. 7B is a plan view of the high-density structure shown in FIG. 7A, in accordance with some embodiments;
FIG. 8, 9, 10, 11 and 12 are cross-sectional views depicting the formation of a high-density MIM capacitor structure as the methods shown in FIG. 5 are practiced, in accordance with some embodiments;
FIG. 13 is a cross-sectional view depicting high-density MIM capacitor structure including multiple composite insulator films, in accordance with some embodiments;
FIG. 14 is a cross-sectional view illustrating a microelectronic device assembly including an embedded high-density MIM capacitor structure; in accordance with some embodiments;
FIG. 15A illustrates a FET structure including a composite gate insulator film, in accordance with some embodiments;
FIG. 15B is a cross-sectional view of the FET structure in FIG. 15A, in accordance with some embodiments;
FIG. 16 illustrates a mobile computing platform and a data server machine employing an IC including MIM/MOS capacitors with a composite insulator film in accordance with some embodiments; and
FIG. 17 is a functional block diagram of an electronic computing device that may be included with a mobile or server computing platform, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

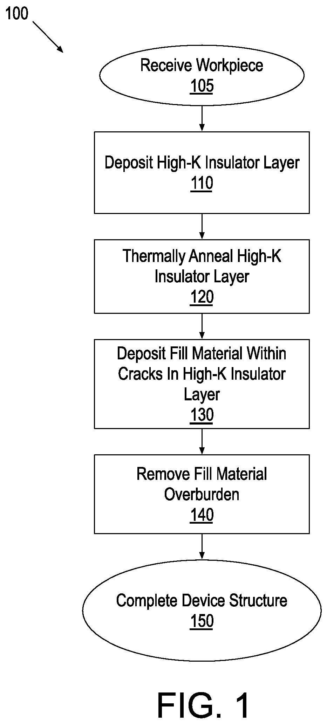

FIG. 1 is a flow diagram illustrating ALD-based methods 100 for forming a composite thin film insulator with high capacitance and low electrical leakage, in accordance with some embodiments. Methods 100 begin at input 105 where a suitable IC workpiece, such as a 300 mm semiconductor material wafer, is received. The workpiece may include any number of substrate structures as fabricated according to any suitable techniques upstream of methods 100. In some embodiments, a substrate structure received at block 105 includes a first (e.g., lower) capacitor electrode.

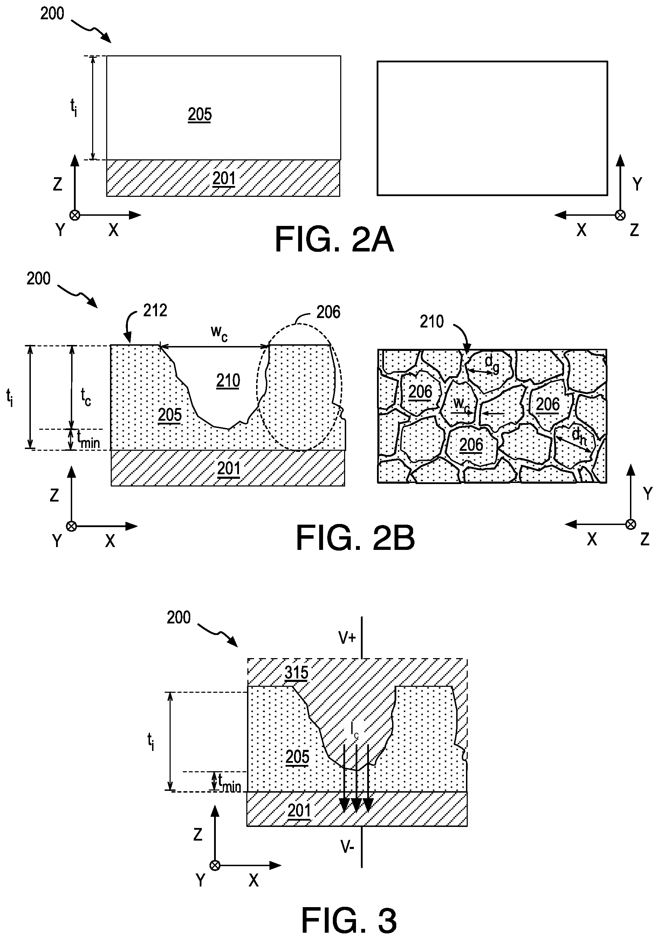

At block 110, an insulator thin film of a composition suitable for a high dielectric constant is deposited. In exemplary embodiments, block 110 entails one or more first cyclic ALD processes. FIG. 2A is a cross-sectional view illustrating a MIM capacitor structure 200 following deposition of an electrical insulator 205 having an as-deposited film thickness tᵢ over a first electrode 201. In exemplary embodiments, film thickness tᵢ is 1-20 nm, although other thicknesses may also be suitable.

Electrode 201 may include any suitably conductive material, such as a metal or carbon. In some metal embodiments, electrode 201 is titanium or a nitride thereof (TiN, e.g., primarily titanium and nitrogen). In some embodiments, electrode 201 is or comprises another metallic compound of titanium (e.g., including oxygen). In other embodiments, electrode 201 is one or more of tungsten (W), tantalum (Ta) ruthenium (Ru), iridium (Ir), aluminum (Al), copper (Cu), cobalt (Co), chromium (Cr), molybdenum (Mo), niobium (Nb) nickel (Ni), gold (Au), or platinum (Pt), an oxide thereof (e.g., RuOx, IrOx, MoOx, NbOx, TaOx, etc.) a nitride thereof, or another compound thereof. In some carbon embodiments, electrode 201 is primarily carbon, and may be substantially pure carbon.

Electrical insulator 205 may be deposited to have any composition that can achieve a high relative permittivity, and in exemplary embodiments electrical insulator 205 is of a chemical composition that can result in a dielectric constant of at least 20. In some advantageous embodiments, insulator 205 is a crystalline film, or layer, as deposited. The crystalline film has a microstructure with regions of uniform atomic lattice structure. Although crystalline, insulator 205 may be polycrystalline, comprising many crystalline grains (or crystallites). Adjacent ones of the grains interface at grain boundaries, which are discontinuities between the crystal structures of the adjacent grains.

The chemical composition of insulator 205 may vary with implementation. In some embodiments, the composition of insulator 205 is substantially homogeneous over thickness tᵢ. Insulator 205 is advantageously a metal oxide, such as a perovskite oxide. In some examples, the perovskite oxide is a titanium oxide such as BTO (e.g., BaTiO₃), STO (e.g., SrTiO₃), or BSTO (e.g., BaSrTiO₃). In some other embodiments, the metal oxide is titanium oxide (TiO₂). In other embodiments, the metal oxide is fluorite binary oxide, such as zirconium oxide, ZrO₂ (i.e., a material consisting essentially of zirconium and oxygen), or hafnium oxide, HfO₂ (i.e., a material including hafnium and oxygen). In some zirconium oxide embodiments, the zirconium oxide is approximately stoichiometric having not less than thirty atomic percent zirconium and not less than sixty atomic percent oxygen. In some hafnium oxide embodiments, the hafnium oxide is approximately stoichiometric hafnium oxide having not less than thirty atomic percent hafnium and not less than sixty atomic percent oxygen. In other examples, the metal oxide is a compound of Zr, Hf and oxygen.

Returning to FIG. 1, methods 100 continue at block 120 where a post-deposition thermal anneal is performed. The thermal anneal may comprise any technique capable of exposing the insulator deposited at block 110 to an elevated temperature of at least 450°C, and advantageously of 550°C, or more. The thermal anneal may alter the crystalline phase(s) present within the insulator film, which is illustrated in FIG. 2B as a change in field lines. The thermal anneal advantageously results in a higher dielectric constant, for example by imparting a particular crystal phase to a various grains within the insulator film.

In the example illustrated in FIG. 2B, insulator 205 comprises one or more crystal phases associated with high relative permittivity. For zirconium oxide or hafnium oxide embodiments, a thermal anneal may advantageously cause a majority of grains to be in tetragonal phase, although some grains of another phase (e.g., monoclinic) may remain within insulator 205. For titanium oxide embodiments, a dielectric constant even higher than that of hafnium and/or zirconium oxides is possible where a significant portion of grains in insulator 205 enter the rutile phase, although some grains of another phase (e.g., anatase) may remain within insulator 205.

The inventors have determined that high temperature anneals useful for achieving a desired high-k material phase from an insulator material formed with ALD can induce cracks, gaps, or valleys within the deposited film. As further shown in FIG. 2B, a thermal anneal may form a crack 210 extending a depth or thickness t_{c} from a top surface 212 of two adjacent hillocks or islands 206. The crack thickness t_{c} can be a significant portion of the as-deposited insulator film thickness tᵢ. In some examples, crack thickness t_{c} is over 75% of film thickness tᵢ and may even be 80-90% of thickness tᵢ. Crack thickness t_{c} is however generally less than 100% of thickness tᵢ such that insulator 205 has a non-zero minimum thickness tₘᵢₙ within a valley between two adjacent hillocks. Cracks 210 have a largest width w_{c} proximal to top surface 212. Crack width w_{c} is generally around order of magnitude smaller than an average diameter of the grains present within insulator 205.

As further illustrated in the plan view of FIG. 2B, for embodiments where grain diameter g_{d} has a range of 100-200 nm, crack width w_{c} may be in the range of 20-30 nm. As also shown in the plan view, cracks 210 can cause insulator 205 to appear to be composed of multiple isolated mesas, hillocks, or islands 206 within an area of the insulator because cracks 210 are a network of continuous moats around each hillock 206. Although a hillock 206 may be single crystalline, dimensions of a hillock 206 may be significantly larger than a grain diameter and hence one hillock 206 may be comprised of multiple (e.g., 1-5) crystal grains. Hillock diameter dₕ may vary widely, for example from approximately equal to the crack width w_{c} to 10-30 times the crack width w_{c}.

As further illustrated in FIG. 3, if insulator hillocks 206 are subsequently capped with a hypothetical top electrode 315, a voltage differential applied across electrodes 201 and 315 (e.g., during operation of MIM capacitor 200) could induce high electrical leakage currents *I_{c}* through regions between the hillocks where insulator 205 has a minimum thickness tₘᵢₙ. Leakage currents *I_{c}* degrade the performance and/or reliability of MIM capacitor structure 100 (FIG. 1). Accordingly, prior to forming another electrode, methods 100 continue at block 130 where an electrically insulative fill material is deposited within the cracks or gaps of the high-k insulator film to form a composite high-k insulator.

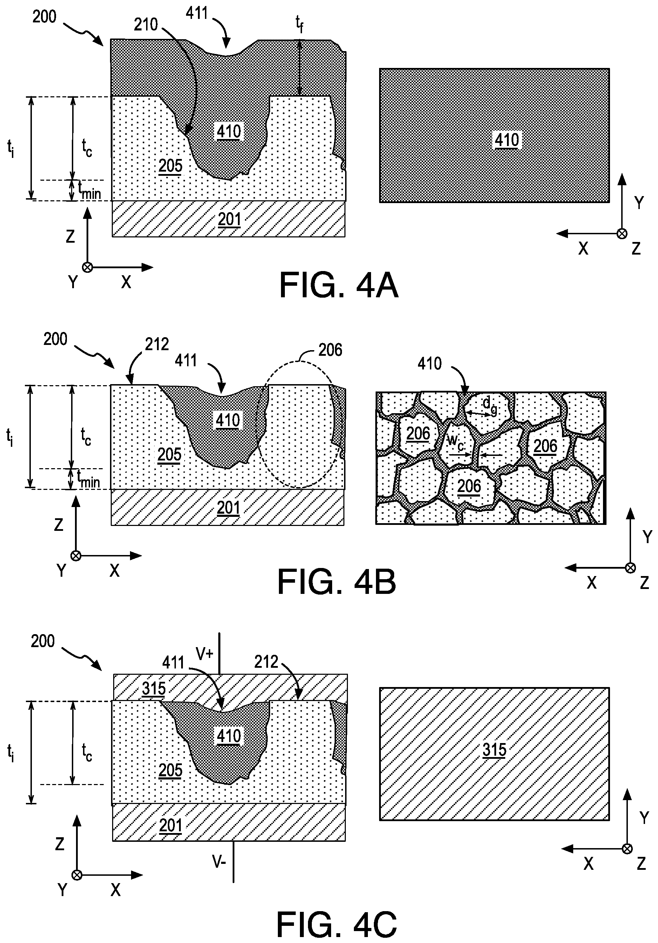

In exemplary embodiments, the fill material is deposited at block 130 with one or more second (post-anneal) ALD processes. The ALD process(es) practiced at block 130 may vary with the composition of the fill material. In some exemplary embodiments further illustrated in FIG. 4A, a sufficient number of ALD cycles are performed to substantially fill the cracks or gaps with another insulator 410. Insulator 410 may therefore be deposited to a fill thickness t_{f} of one-half of crack thickness t_{c}, or more, with a top surface of insulator 410 then having only a slight depression or dimple 411 following a centerline of the crack 210. In some specific examples where t_{c} is 20-30 nm, fill thickness t_{f} is 10-15 nm.

The chemical composition and microstructure of insulator 410 may vary with implementation. In some embodiments, insulator 410 is less crystalline than insulator 205. Insulator 410 may be, for example, substantially amorphous, lacking the long-range atomic order of crystalline insulator 205. Amorphous insulators of many compositions are known to impede current flow as electron mobility in amorphous materials is typically much lower than in polycrystalline materials. However, insulator 410 may also be crystalline, particularly where the chemical composition of insulator 410 ensures a high electrical barrier as a result of a large band gap or large band gap offset relative to insulator 205.

In some examples, insulator 410 has the same chemical composition as insulator 205, but is less crystalline than insulator 205 and/or predominantly in a different crystalline phase than insulator 205. For examples where insulator 205 is a crystalline metal oxide compound, insulator 410 may be that same metal oxide. In some embodiments where insulator 205 is hafnium oxide or zirconium oxide and is more tetragonal than monoclinic, insulator 410 is also hafnium oxide or zirconium oxide, but is less tetragonal and more monoclinic than insulator 205, or is in an amorphous state. Although with an alternative microstructure these metal oxides do not have as high of a dielectric constant as insulator 205, these material compounds will nevertheless significantly reduce the electrical leakage of insulator 205 from a reference level that would occur if electrode material was allowed to instead fill cracks 210. In some other embodiments wherein insulator 205 is a titanium oxide more a first phase (e.g., rutile) than a second phase, insulator 410 is also a titanium oxide, but more in the second phase than the first phase (e.g., rutile), or is in an amorphous state. In some specific examples where insulator 205 is one of STO, BTO or BSTO, insulator 410 is also one of STO, BTO or BSTO, but is in a less crystalline and/or alternative phase, or is in an amorphous state.

In some other examples, insulator 410 has a different chemical composition than insulator 205. For such embodiments, insulator 410 may also have a less crystalline microstructure than insulator 205, or not. Although insulator 410 might be silicon-based (e.g., SiO₂), for embodiments where insulator 205 is a crystalline metal oxide compound, insulator 410 is advantageously another metal oxide compound (crystalline or amorphous) of a different chemical composition. In some embodiments where insulator 205 is hafnium oxide, insulator 410 is other than hafnium oxide, and may be zirconium oxide or aluminum oxide, for example. In some embodiments where insulator 205 is zirconium oxide, insulator 410 is other than zirconium oxide, and may be hafnium oxide or aluminum oxide, for example. In some embodiments wherein insulator 205 is a first titanium oxide (e.g., a first of STO, BTO or BSTO), insulator 410 is a second titanium oxide (e.g., a second of STO, BTO, or BSTO). For such embodiments, insulator 205 may again be mostly in a first phase (e.g., rutile) advantageous for a high relative permittivity, while insulator 410 is either mostly in a second phase or in an amorphous state associated with a lower relative permittivity. In some other embodiments where insulator 205 a titanium oxide (e.g., a first of STO, BTO or BSTO) insulator 410 is other than a titanium oxide, such as one of aluminum oxide, hafnium oxide or zirconium oxide. For such embodiments, insulator 205 may again be mostly in a first phase (e.g., rutile) advantageous for a high relative permittivity, while insulator 410 may be mostly in a second phase (e.g., monoclinic) or in an amorphous state that is similarly associated with lower relative permittivity.

Returning to FIG. 1, since the insulator deposited at block 130 is expected to have a lower dielectric constant than that of the insulator deposited at block 110 (and that the second deposition will increase the cumulative insulator thickness), methods 100 continue at block 140 where overburden associated with block 130 is removed. Advantageously, the nominal thickness of insulator deposited at block 130 is removed at block 140. A top surface of the insulator deposited at block 110 may therefore be exposed by the process performed at block 140. Accordingly, the insulator deposited at block 130 does not increase capacitor electrode spacing beyond the spacing defined by the thickness of the insulator deposited at block 110. Furthermore, the effective dielectric constant of a composite of the insulators deposited at blocks 110 and 130 is dominated by the high-k insulator deposited at block 110.

In some embodiments, block 140 comprises a planarization process (e.g., chemical mechanical planarization), which removes a target thickness of insulator material to ensure the insulator deposited at block 130 remains only within cracks and below a top surface of the insulator deposited at block 110. Depending on the differences in the composition and/or microstructure of the insulators, CMP may remove the insulator deposited at block 130 with adequate selectively to the insulator deposited at block 110. In alternative embodiments, block 140 comprises an etch (e.g., an atomic layer etch) process, which similarly removes a target thickness of insulator material to ensure the insulator deposited at block 130 remains only within cracks below the top surface of the insulator deposited at block 110. Many ALE etch processes are known to be suitable for insulator materials and the choice of insulator material deposited at block 130 may be selected, at least in part, based on availability of an ALE etch process suitable for block 140. For example, aluminum oxide may be deposited at block 130 at least in part because ALE processes suitable for etching aluminum oxide may then be practiced at block 140. Aluminum oxide ALE processes may offer advantageous selectivity over a high-k insulator, such as STO, BTO, or hafnium oxide, deposited at block 130.

In the examples illustrated by FIG. 4B, a thickness of insulator 410 has been removed to expose top surface 212 of insulator 205 within regions where insulator 205 is of maximum thickness (e.g., approximately thickness tᵢ). For specific examples where 10-15 nm is deposited at block 130, 10-15 nm of the insulator is removed at block 140. In the illustrated example, recess 411 has been translated into the remaining portion of insulator 410, which is indicative of an atomic layer etchback process. As depicted in the plan view, hillocks 206 are exposed with insulator 410 only remaining with in the gap between adjacent hillocks 206. Accordingly, insulator 410 has a maximum thickness of approximately the crack thickness t_{c}, but may be significantly (e.g., 10-20%) more or less than crack thickness t_{c} as a function of how the overburden of block 130 is removed at block 140.

Returning to FIG. 1 with a composite insulator now formed, methods 100 end at output 150 where the device structure is completed. In exemplary MIM capacitor embodiments, the capacitor structure may be completed by depositing an electrode material over the composite film comprising insulators 205 and 410. Electrode material may be deposited by any technique suitable for the material, such as physical vapor deposition (PVD) or ALD, for example depending on the severity of the topography present within a MIM capacitor structure. In the examples illustrated by FIG. 4C, top electrode 315 has been deposited directly on top surface 212 of insulator 205 and in direct contact with insulator 410. Nevertheless, spacing between electrodes 201 and 315 is approximately the as-deposited thickness tᵢ of insulator 205. With an application of a voltage differential across electrodes 201 and 315, MIM capacitor structure 200 displays an effective dielectric constant exceeding that of the as-deposited insulator 205 (i.e., pre-anneal). Accordingly, MIM capacitor structure 200 has the advantage of a much higher dielectric constant attributable to the thermal anneal. However, with the addition of insulator 410, electrical leakage of MIM capacitor structure 200 is significantly below that of a capacitor structure including only the annealed insulator. Accordingly, MIM capacitor structure 200 also has the advantage of a much lower leakage current attributable to the fill insulator.

The MIM capacitor structures described above, and the methods of forming such structures described herein, may be integrated into a wide variety of ICs and devices that include such ICs. For example, MIM capacitor structures incorporated in IC power supply circuitry may include the composite insulators described above. An IC power supply may include switching capacitors or bypass (decoupling) capacitors tasked with removing voltage ripples and either of these types of capacitors may be implemented (either within an IC die or within a package of an IC die) with the composite insulators described above. In other examples, MIM capacitor structures incorporated into an electronic memory (e.g., embedded DRAM) may include the composite insulators described above. In still other embodiments, MOS capacitor structures may similarly incorporate the composite insulators described above. Methods 100 may therefore be applied to methods for fabricating a wide variety of capacitor architectures.

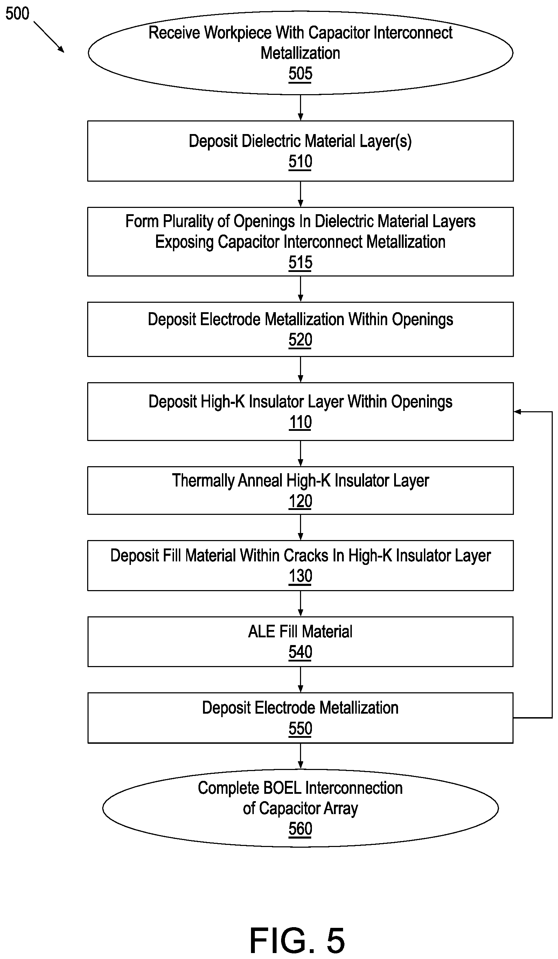

FIG. 5 is a flow diagram illustrating methods 500 for forming a high-density MIM capacitor structure, in accordance with some embodiments where ALD techniques for forming the insulator film are needed because a device structure has aspect ratios that are too extreme for PVD techniques.

Methods 500 begin at input 505 where a workpiece including capacitor interconnect metallization is received. The workpiece may again be any 300 mm wafer, for example. The workpiece may include MOSFETs and capacitor storage node interconnect metallization embedded in a planarized dielectric over the MOSFETs. At block 510, one or more dielectric material layers are deposited with any deposition process suitable for the material(s). At this point, device topography may be limited and so either PVD or chemical vapor deposition (CVD) deposition techniques may be practiced. At block 515, a plurality of via openings are formed through the dielectric material layers, for example exposing at least a portion of the capacitor storage node interconnect metallization at a bottom of each opening.

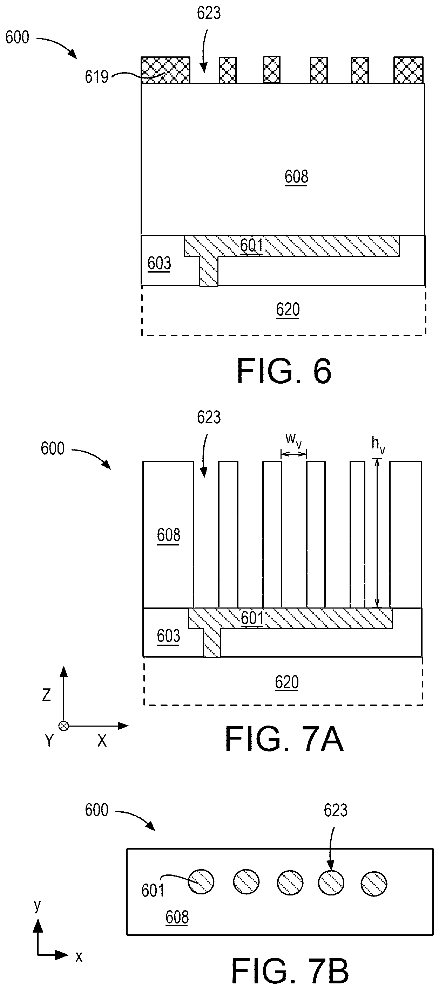

FIG. 6 and 7A illustrate cross-sectional views of a portion of a capacitor array structure 600 evolving as blocks 510 and 515 are practiced, in accordance with some embodiments. As shown in FIG. 6, capacitor storage node interconnect metallization 601 is embedded within a dielectric material 603 and over a substrate 620. Substrate 620 may include circuitry and is illustrated with dashed line as it may further include storage node access transistors having any suitable architecture, such as, but not limited to MOSFETs or TFTs. One or more dielectric materials 608 are deposited over capacitor storage node interconnect metallization 601. Dielectric materials 608 may include any number of layers of any known dielectric materials. Although the compositions may vary, in some examples dielectric materials 608 include a layer that is predominantly silicon and oxygen (e.g., SiOₓ). In some embodiments, dielectric materials 608 include a layer that is predominantly silicon and nitrogen (e.g., SiNₓ). Via openings 623 are defined in a mask material 619, which is over dielectric materials 608.

As shown in FIG. 7A, via openings 623 are etched through dielectric materials 608, exposing capacitor storage node interconnect metallization 601. Via openings 623 have a via width wᵥ and a via height hᵥ. In exemplary embodiments, vie height hᵥ is at least 8 times via width wᵥ, and may be 12-20 times via width wᵥ, or more. FIG. 7B further illustrates a top-down (plan) view of portion of capacitor array structure 600, in accordance with some via embodiments. In this example, via openings 623 have a substantially round area or footprint. In other embodiments, openings 623 may instead be elongated trenches having a longitudinal length (e.g., in the y-dimension of FIG. 7A) that is many times the via (trench) width wᵥ.

Returning to FIG. 5, methods 500 continue at block 520 where the via (trench) openings are lined with a first electrode material. In exemplary embodiments, the first electrode material is deposited by CVD, and more advantageously with a low temp (e.g., <450 °C) ALD process suitable for a forming a low-stress conductive (e.g., metal) film. At block 110 the high-k insulator material is deposited over the first electrode material, further lining the via (trench) openings. In exemplary embodiments, the high-k insulator is deposited with an ALD process suitable for forming a precursor film that can then be thermally annealed at block 120 to achieve a higher dielectric constant, substantially as described above.

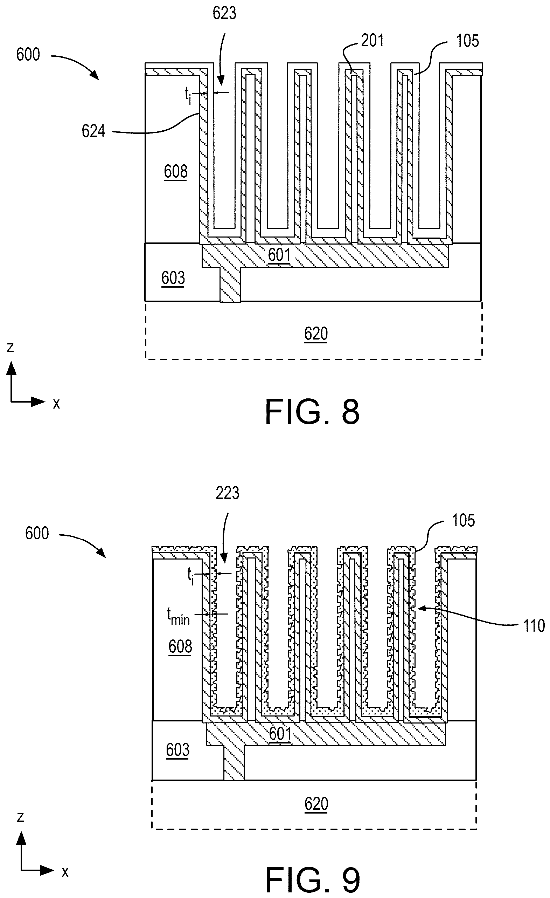

In the examples shown by FIG. 8, electrode 201 has been conformally deposited upon an opening sidewall 624 of dielectric material 608, for example defining a cylindrical lining of opening 623. While electrode 201 may be a variety of metals and metalloids, such as any of those described above for electrode 201, in some embodiments electrode 201 comprises metal and nitrogen (e.g., TiN). Such films, when deposited by ALD, are low stress, allowing them to stand with minimal support from surrounding materials.

Insulator 105 similarly forms a lining of initial thickness t₁ along sidewalls of each opening 623. Insulator 105 may be any of the compositions described above, such as, but not limited to, metal oxides (e.g., hafnium oxide, zirconium oxide, or a titanium oxide). FIG. 9 further illustrates capacitor array structure 600 following a thermal anneal of insulator 105. As shown, insulator 105 now comprises cracks or gaps 210. Since insulator 105 is a lining along a sidewall of opening 623, cracks 210 are essentially smaller trenches along a length of the sidewall of a larger trench. The smaller trenches where insulator has a minimum thickness tₘᵢₙ substantially normal to the sidewall are to be filled with another insulator that can be adequately deposited upon the sidewall of the larger trenches. Deposition of the supplemental insulator is to leave adequate volume that an electrode material may be subsequently deposited within openings 623.

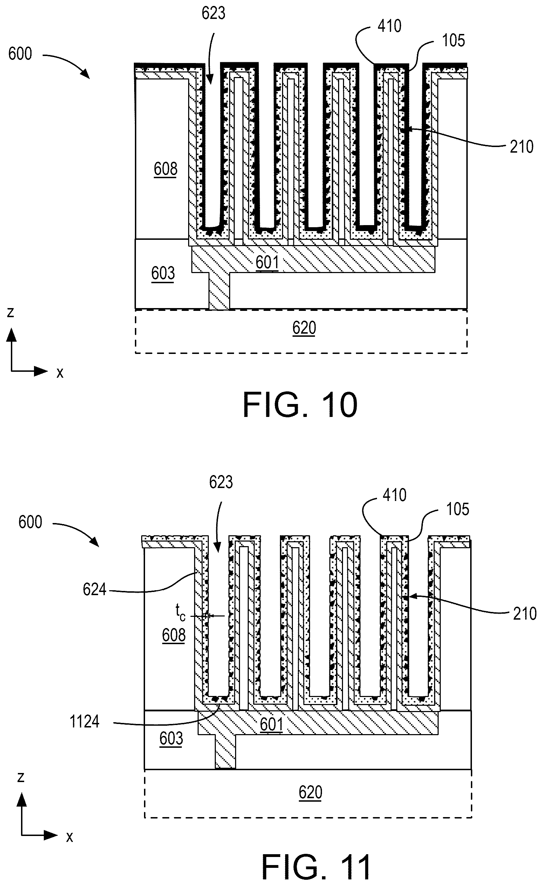

Returning to FIG. 5, methods 500 continue with the deposition of the second insulator at block 130. In exemplary embodiments further illustrated in FIG. 10, insulator 410 is deposited with an ALD technique to deposit a highly conformal film and to avoid occluding or key-holing the via (trench) openings 623. As shown, insulator 401 has been deposited to a thickness sufficient to substantially fill cracks 210 and fully encapsulate insulator 105 without occluding openings 623. For examples where

Returning to FIG. 5, methods 500 continue at block 540 with an atomic layer etch process that removes a thickness of the insulator material deposited at block 130. Because of the high aspect ratio of openings 623, ALE is favored for the examples further illustrated in FIG. 11, but other techniques (e.g., CMP) may be suitable for structures with less topography. In the example shown, an ALE process removes substantially the full deposited thickness of insulator 410 from the thickest regions of insulator 105 (e.g., having the initial thickness tᵢ) along both trench sidewall 624 and trench bottom 1124. The ALE process, however, is controlled to ensure that insulator 410 is retained within cracks 210 where the effective thickness of insulator 410 is greatest. Following the etch process, insulator 410 has a maximum thickness t_{c} where insulator 105 is of minimum thickness tₘᵢₙ and has a thickness of nil (i.e., zero) where insulator 105 is of maximum thickness tᵢ.

With the composite insulator now formed, methods 500 (FIG. 5) continue at block 550 where electrode metallization is deposited. In exemplary embodiments, the electrode material is advantageously deposited with an ALD process to adequately line the high aspect ratio openings. The ALD process may be a low temp (e.g., <450 °C) deposition, for example. Alternatively, a less-conformal PVD deposition may be performed at block 550. In the examples illustrated by FIG. 11, electrode material 315 has been deposited nearly conformally upon inner sidewalls of each opening 623. While electrode material 315 may have any of the compositions described above in the context of methods 100 and/or MIM structure 200, in some embodiments electrode 315 has the same composition as electrode 201, and may, for example comprise metal and nitrogen (e.g., TiN).

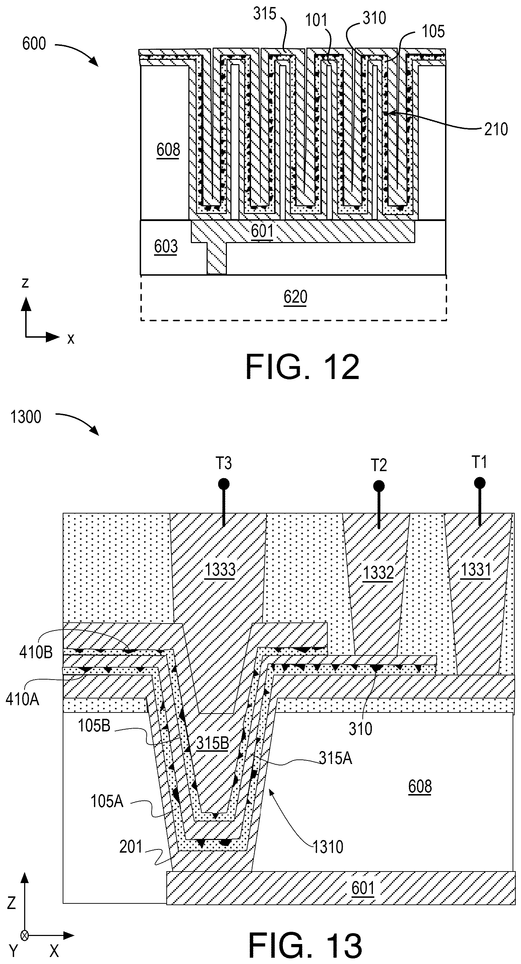

Methods 500 (FIG. 5) are completed at output 560 where any back-end-of-line IC metallization process (e.g., dual or single damascene processing, etc.) may be practiced to interconnect the capacitor array structure to other IC nodes. For example, in FIG. 12, electrode material 315 may be interconnected to a circuit node common to all capacitors of array structure 600. For addressable charge storage applications, a subset of the capacitors (e.g., one or more) in array structure 600 may interconnected to different circuit nodes by metallization 601(e.g., the illustrated row of capacitors may be coupled to a same word line, etc.). For nonaddressable charge storage applications, metallization 601 may interconnect all capacitors array structure 600 to a second circuit node.

In methods 500 (FIG. 5), blocks 110-550 may be repeated any number of times to fabricate capacitor structures that include multiple composite insulator layers. Each of the composite insulator layers include both a thermally annealed high-k insulator and a fill insulator. Such an iterative process may be practiced, for example, to fabricate capacitor structures that include three or more electrodes with individual composite insulator layers between various ones of the electrodes. Generally, successive thermal anneals performed at each iteration of block 120 will increase crystallinity of the high-k insulator layer deposited at block 110 in that same iteration and can induce crack formation within that film. Consecutive thermal anneals have not be found to significantly alter (e.g., increase) crystallinity of the insulators deposited in a prior iteration of either block 110 or block 130.

FIG. 13 is a cross-sectional view depicting high-density MIM capacitor structure 1300 including two composite insulator films. MIM capacitor structure 1300 may be fabricated by practicing methods 500 (FIG. 5) with two iterations of blocks 110-550, for example. However, MIM capacitor structure 1300 may also be fabricated according to alternative methods.

As shown in FIG. 13, terminals T1, T2, and T3 are coupled to a tri-layered capacitor structure 1310. Terminal T1 is coupled to a lowermost capacitor electrode 201 through a metallization via 1331. Terminal T1 may further comprise any of a metallization line, a solder bump, or a bond pad, etc. Terminal T3 is coupled to an uppermost capacitor electrode 315B through a metallization via 1333. Terminal T3 may similarly comprise a metallization line, a solder bump, or a bond pad, etc. Terminal T2 is coupled to an intervening capacitor electrode 315A through a metallization via 1332. Terminal T2 may similarly comprise a metallization line, a solder bump, or a bond pad, etc. A first composite insulator comprising insulator 105A filled with insulator 410A is between capacitor electrodes 201 and 315A. A second composite insulator comprising insulator 105B filled with insulator 410B is between capacitor electrodes 315A and 315B. Accordingly, capacitor structure 1300 has a first capacitance across terminals T1 and T2, a second capacitance across terminals T2 and T3.

Capacitor structure 1300 therefore includes two iterations of a composite insulator comprising both an annealed high-k material having high crystallinity and a insulative fill material at least partially occupying cracks, moats or valleys within the annealed high-k material. As described above, the materials within a composite insulator may have different chemical compositions and/or microstructures. Capacitor structure 1300 has a high-density architecture similar to capacitor structure 600 (FIG. 12) with each composite insulator lining a sidewall of a trench or via.

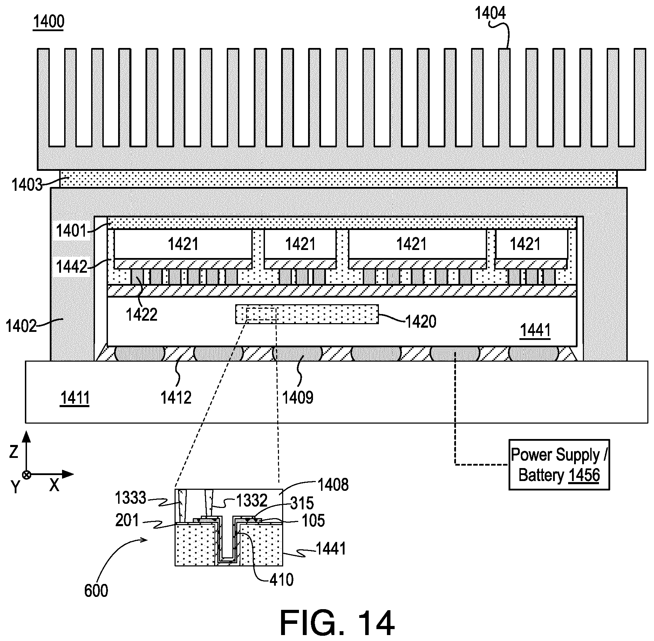

The capacitor structures described above may be implemented within an IC die or within a package of an IC, for example. FIG. 14 is a cross-sectional view illustrating a microelectronic device assembly 1400, which includes a high-density MIM capacitor structure embedded within an IC die package, in accordance with some embodiments. Microelectronic device assembly 1400 includes a plurality of IC dies 1421 joined to package substrate 1441 with die-level interconnects 1422 and optionally embedded in a mold material 1442. However, any single IC die, 3D stacked multichip device, multi-chip composite structure, or the like may be similarly assembled within a microelectronic device assembly.

A thermal interface material (TIM) 1401 is between IC dies 1421 and a heat spreader and/or lid 1402, which extends beyond a perimeter of package substrate 1441, and is mounted to board 1411. Another TIM 1403 is between heat spreader 1402 and a thermal dissipation device 1404, which may be a heat sink, heat pipe or other thermal solution.

Package substrate 1441 is coupled to a board 1411 with package-level interconnects 1409 (e.g., solder features) that may be at least partially surrounded by underfill material 1412. Board 1411 may include any suitable substrate such as a motherboard, interposer, or the like. Microelectronic device assembly 1400 is coupled to a power supply 1456, for example through one or more of board 1411 and package substrate 1441. Power supply 1456 may include a battery and multi-rail power supply circuitry, such as a switching supply with a voltage converter, etc.

Package substrate 1441 may comprise one or more insulator layers and routing metallization layers. Insulator layers may be a portion of a package substrate or a build-up layer over or on the package substrate. In some embodiments, package substrate 1441 includes an inorganic substrate material, such as glass. For example, package substrate 1441 may be a glass core substrate. In some embodiments, substrate 1441 includes an amorphous solid glass layer. In some embodiments, substrate 1441 includes a layer of glass, which, for example, is one of aluminosilicate, borosilicate, alumino-borosilicate, silica, or fused silica. The layer of glass may include one or more of additives including Al₂O₃, B₂O₃, MgO, CaO, SrO, BaO, SnO₂, Na₂O, K₂O, P₂O₃, ZrO₂, Li₂O, Ti, or Zn. For example, the layer of glass may include an additive including one or more of aluminum, boron, magnesium, calcium, strontium, barium, tin, sodium, potassium, phosphorous, zirconium, lithium, titanium, or zinc. In some embodiments, the layer of glass may include silicon and oxygen and one or more of aluminum, boron, magnesium, calcium, strontium, barium, tin, sodium, potassium, phosphorous, zirconium, lithium, titanium, and zinc. In some embodiments, the layer of glass includes at least 23 weight percent silicon and at least 26 weight percent oxygen and further includes at least 5 weight percent aluminum. In some embodiments, the layer of glass is rectangular in shape in a plan view. However, substrate 1441 may have other shapes. In some embodiments, substrate 1441 has a thickness in the range of 50 microns to 1.4 mm (i.e., in the z-direction).

As shown in FIG. 14, a power supply component 1420 is embedded within package substrate 1441. In exemplary embodiments, power supply component 1420 comprises one or more capacitor array structures 600 that further include a composite insulator, for example substantially as described elsewhere herein. As illustrated, capacitor array structure 600 is formed within an opening or trench 402 defined in substrate 1441. The opening or trench may extend partially or entirely through a thickness of substrate 1441. Capacitor array structure 600, again including insulator 105 filled with insulator 410 between electrodes 201 and 315, is within the opening or trench in substrate 1441 as an embedded device suitable as a power supply coupling capacitor, etc.

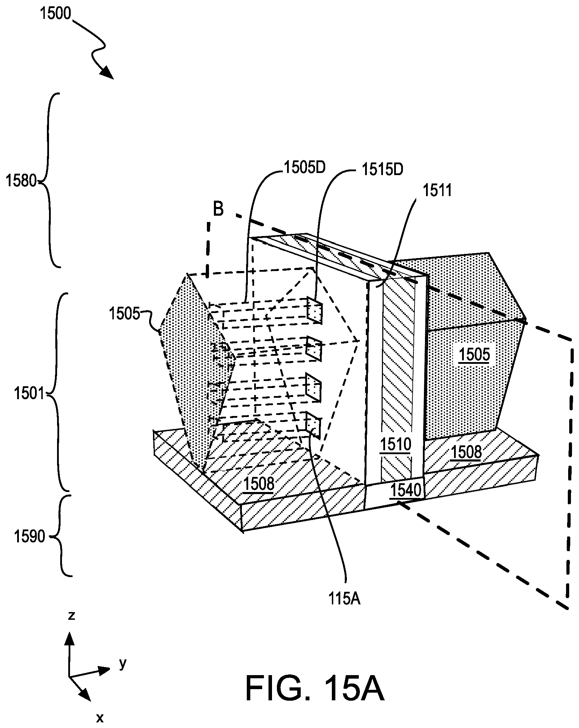

In some embodiments, the composite insulator films described herein are integrated into a FET, for example as a gate insulator film. As for MIM capacitors, the high relative permittivity and low electrical leakage of the composite insulator films described herein are also advantageous properties of a gate insulator. FIG. 15A illustrates an IC structure 1500 including a transistor structure 1501 with a composite gate insulator film, in accordance with some embodiments.

IC structure 1500 includes one or more front-side metallization levels 1580 over a "top" or "front" side of transistor structure 1501, and one or more back-side metallization levels 190 over (under) a "bottom" or "back" side of transistor structure 1501. Structural aspects of front-side metallization levels 1580 and back-side metallization 1590 are not depicted in FIG 15A to avoid obscuring transistor structure 1501. Front-side metallization levels 1580 may have any known structure, and any number of levels interconnecting one or more transistor terminals with other nodes in a circuit. Similarly, back-side metallization levels 1590 may have any known structure, and any number of levels interconnecting one or more transistor terminals with other nodes in the circuit. In some exemplary embodiments, there are more levels (e.g., 6-8, or more) front-side metallization levels 1580 than back-side metallization levels 1590 (e.g., 1-4 levels). For such embodiments, front-side metallization levels 1580 may be readily distinguished from back-side metallization levels 1590 even where a double-side IC structure is inverted from the orientation illustrated. Channel region 1515A is nearest to back-side metallization levels 1590, and is therefore referred as a "bottom," or "lower," channel region. In contrast, channel region 1515D is nearest front-side metallization levels 1580 and may therefore be referred to as a "top," or "upper," channel region.

In FIG. 15A, plane B is a "fin-cut" plane that passes through a transverse length of channel regions 1515A-1515D and passes through a longitudinal length of a gate electrode 1510. As further illustrated, source and drain regions 1505 are electrically and physically coupled to opposite sides of channel regions 1515A-1515D. In this example, source and drain regions 1505 comprise faceted epitaxial material that has been grown, for example laterally from an end portion of channel regions 1515A-1515D embedded with in a spacer dielectric material 1511, or from cantilevered source/drain nanowire ends (e.g., 1505D) drawn in dashed line.

Source and drain regions 1505 need not be epitaxial material, in which case the illustrated facets may not be present. Source and drain regions 1505 also need not be merged into a unitary body, in which case cantilevered source/drain nanowire ends (e.g., 1505D) may be individually contacted by a terminal contact metal. In the illustrated example, back-side metallization levels 1590 include a back-side source and drain contact 1508 that is in contact with source and drain regions 1505. Although not depicted for the sake of clarity, front-side metallization levels 1580 may include a front-side source and/or drain contact that is similarly in contact with one or more of source and drain regions 1505. Likewise, front-side metallization levels 1580 and/or back-side metallization levels 1590 may further include a contact to gate electrode 1510. Gate electrode 1510 is between source and drain material 1505, with intervening spacer dielectric material 1511 between gate electrode 1510 and source and drain material 1505. In the illustrated example, a dielectric material 1540 is under gate electrode 1510 where gate electrode 1510 extends laterally beyond channel regions 1515A-1515D.

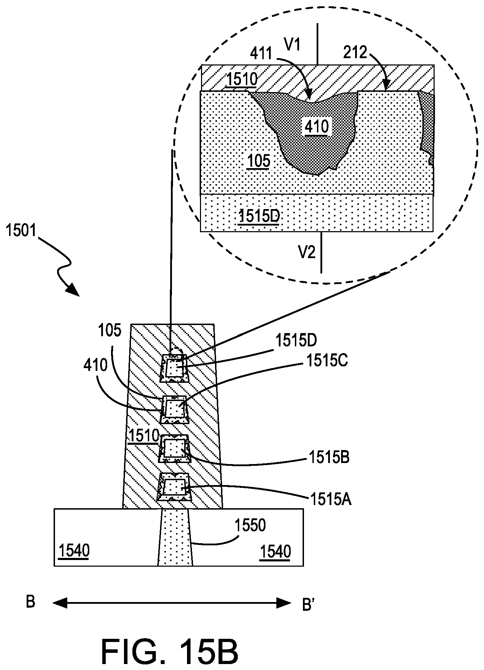

FIG. 15B is a cross-sectional view of the FET structure 1501 along the B plane illustrated in FIG. 15A, in accordance with some embodiments. As shown, channel regions 1515A-1515D are bodies of semiconductor material that may have been patterned from a fin in a front (top) side of a substrate material layer, for example. The trapezoidal profiles illustrated for both gate electrode 1510 and channel regions 1515A-1515D are representative of structural asymmetry associated with front-side transistor fabrication. Such asymmetry may be a result of feature sidewall slopes that evolve during subtractive patterning of one or more of a semiconductor fin or gate electrode. Although channel regions 1515A-1515D are illustrated in FIG. 15B as nanowires having a transverse width approximately equal to their vertical thickness, channel regions 1515A-1515D may instead be nanoribbons.

In some embodiments, channel regions 1515A-1515D are crystalline semiconductor. Although the crystalline semiconductor includes polycrystalline thin film material, the crystalline semiconductor may be advantageously substantially monocrystalline. In some such embodiments, the crystallinity of channel regions 1515A-1515D is cubic with the top surfaces nearest to front-side metallization levels 1580 having crystallographic orientation of (100), (111), or (110), for example. Other crystallographic orientations are also possible. In some embodiments, channel regions 1515A-1515D are a substantially monocrystalline group IV semiconductor material, such as, but not limited to substantially pure silicon (e.g., having only trace impurities), silicon alloys (e.g., SiGe), or substantially pure germanium (e.g., having only trace impurities). Channel regions 1515A-1515D may also have any of these same exemplary compositions in alternative polycrystalline or amorphous embodiments, for example where transistor structure 1501 has been fabricated from a thin film semiconductor material layer. Alternative polycrystalline or amorphous embodiments may instead include semiconducting metal oxides, such as IGZO. Although channel regions 1515A-1515D are illustrated as having a substantially homogenous composition, they may alternatively comprise one or more semiconductor heterojunctions that, for example further include a first semiconductor material adjacent to a second semiconductor material.

As further illustrated in FIG. 15B, structure 1501 includes a sub-channel material 1550. Sub-channel material 1550 is under the stack of channel regions 1515A-1515D, under gate electrode 1510, and may be a base of a fin, for example, from which channel regions 1515A-1515D were formed. As such, sub-channel material 1550 may have a composition and/or microstructure similar to channel regions 1515-1515D. For example, in some embodiments where channel regions 1515A-1515D are of a Group IV material (e.g., silicon), sub-channel material 200 is also a Group IV material (e.g., silicon).

Transistor structure 1501 includes a gate stack further including gate electrode 1510 and a composite gate insulator cladding channel regions 1515A-1515D to provide gate-all-around control of channel conductivity. The composite gate insulator includes insulator 105, which may be any insulator materials described above in the context of MIM capacitor structures, for example. Insulator 105 is supplemented with insulator 410, which fills cracks or valleys within insulator 105, for example substantially as described elsewhere herein. Insulator 410 may again have any of the compositions, microstructures, and properties previously described in the context of MIM capacitor structures.

As shown in the expanded view of FIG. 15B, a MOS capacitor structure includes a composite gate insulator comprising insulators 105 and 410 between channel material 1515D and gate electrode 1510. Although gate electrode 1510 is shown as a single monolithic layer, it may instead comprise a workfunction metal over insulators 105 and 410 and a compositionally distinct fill metal.

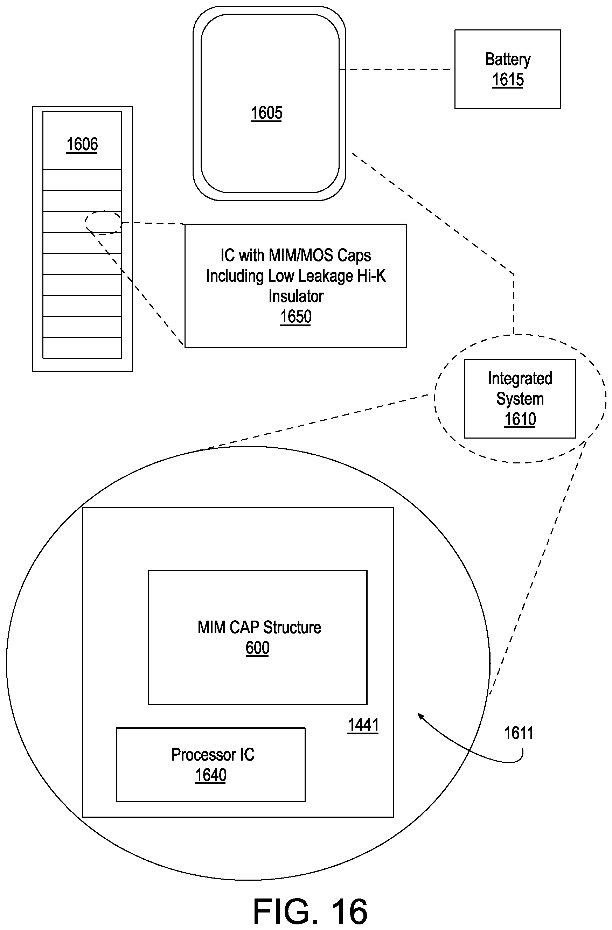

The various capacitor structures, and methods of forming such structures, described herein may be integrated into a wide variety of ICs and computing systems that include such ICs. FIG. 16 illustrates a system in which a mobile computing platform 1605 and/or a data server machine 1606 includes a packaged IC die 1650 comprising a MOS or MIM capacitor with a composite insulator film, for example in accordance with one or more of the embodiments described elsewhere herein. The server machine 1606 may be any commercial server, for example including any number of high-performance computing platforms within a rack and networked together for electronic data processing. The mobile computing platform 1605 may be any portable device configured for each of electronic data display, electronic data processing, wireless electronic data transmission, or the like. For example, the mobile computing platform 1605 may be any of a tablet, a smart phone, laptop computer, etc., and may include a display screen (e.g., a capacitive, inductive, resistive, or optical touchscreen), a chip-level integrated system 1610, and a battery 1615.

Whether disposed within the integrated system 1610 further illustrated in the expanded view 1611, or as a stand-alone packaged chip within the server machine 1606, packaged IC die 1650 may include memory circuitry (e.g., RAM), and/or a logic circuitry (e.g., a microprocessor, a multi-core microprocessor, graphics processor, or the like). At least one of these circuitries comprises a MOS or MIM capacitor structure including a composite insulator, for example in accordance with one or more embodiments described elsewhere herein. Integrated systems 1610 may include a package substrate 1441 that hosts one or more ICs, such as a processor IC 1640. Package substrate 1441 further hosts MIM capacitor array structure 600, for example one or more of the features or attributes described elsewhere herein. In some examples, MIM capacitor array structure 600 is embedded within package substrate 1441, for example as describe elsewhere herein.

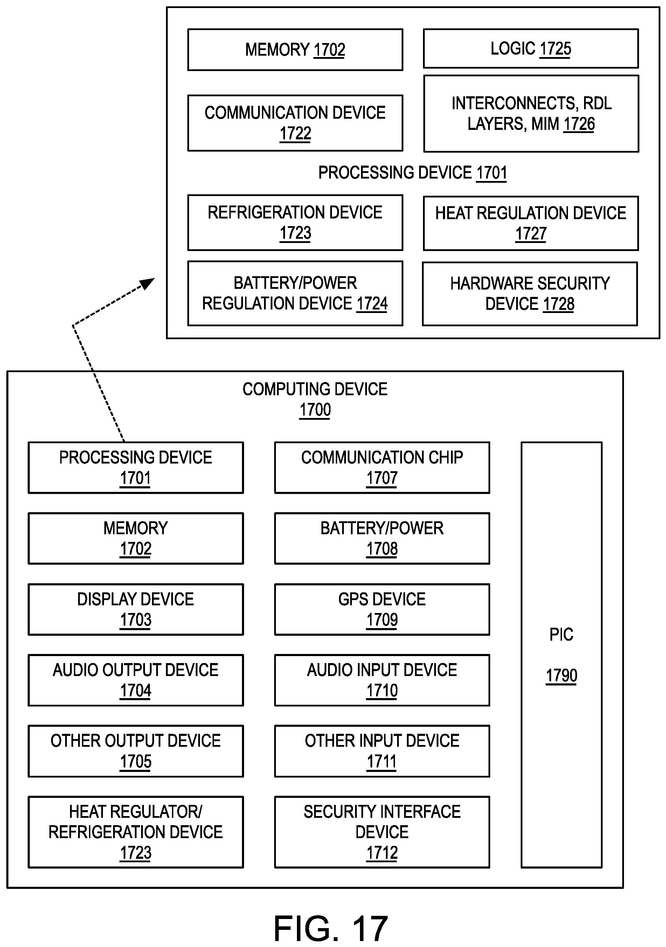

FIG. 17 is a block diagram of a computing device 1700 in accordance with some embodiments. For example, one or more components of computing device 1700 may include any of the transistor structures discussed elsewhere herein. A number of components are illustrated in FIG. 17, but any one or more of these components may be omitted or duplicated, as suitable for the application. In some embodiments, some of the components included in computing device 1700 may be attached to one or more printed circuit boards (e.g., a motherboard). In some embodiments, various ones of these components may be fabricated onto a single system-on-a-chip (SoC) die or implemented with a disintegrated plurality of chiplets or tiles packaged together. Additionally, in various embodiments, computing device 1700 may not include one or more of the components illustrated in FIG. 17, but computing device 1700 may include interface circuitry for coupling to the one or more components. For example, computing device 1700 may not include a display device 1703, but may include display device interface circuitry (e.g., a connector and driver circuitry) to which display device 1703 may be coupled.

Computing device 1700 may include a processing device 1701 (e.g., one or more processing devices). As used herein, the term processing device or processor indicates a device that processes electronic data from registers and/or memory to transform that electronic data into other electronic data that may be stored in registers and/or memory. Processing device 1701 may include a memory 1702, a communication device 1722, a refrigeration/active cooling device 1723, a battery/power regulation device 1724, logic 1725, interconnects 1726, a heat regulation device 1727, and a hardware security device 1728.

Processing device 1701 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable compute units.

Processing device 1701 may include a memory 1702, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, processing 1701 shares a package with memory 1702. This memory may be used as cache memory and may include embedded dynamic random-access memory (eDRAM) or spin transfer torque magnetic random-access memory (STT-M RAM).

Computing device 1700 may include a heat regulation/refrigeration device 1723. Heat regulation/refrigeration device 1723 may maintain processing device 1701 (and/or other components of computing device 1700) at a predetermined low temperature during operation. This predetermined low temperature may be any temperature discussed elsewhere herein.

In some embodiments, computing device 1700 may include a communication chip 1707 (e.g., one or more communication chips). For example, the communication chip 1707 may be configured for managing wireless communications for the transfer of data to and from computing device 1700. The term "wireless" and its derivatives may be used to describe circuits, devices, systems, methods, techniques, communications channels, etc., that may communicate data through the use of modulated electromagnetic radiation through a nonsolid medium.

Computing device 1700 includes a PIC 1790, for example having a photonic integrated WDM source circuit. PIC 1790 may facilitate communication between one or more instances of processing device 1701 and/or one or more instances of memory 1702, for example.

Computing device 1700 may include battery/power circuitry 1708. Battery/power circuitry 1708 may include one or more energy storage devices (e.g., batteries or capacitors) and/or circuitry for coupling components of computing device 1700 to an energy source separate from computing device 1700 (e.g., AC line power).

Computing device 1700 may include a display device 1703 (or corresponding interface circuitry, as discussed above). Display device 1703 may include any visual indicators, such as a heads-up display, a computer monitor, a projector, a touchscreen display, a liquid crystal display (LCD), a light-emitting diode display, or a flat panel display, for example.

Computing device 1700 may include an audio output device 1704 (or corresponding interface circuitry, as discussed above). Audio output device 1704 may include any device that generates an audible indicator, such as speakers, headsets, or earbuds, for example.

Computing device 1700 may include an audio input device 1710 (or corresponding interface circuitry, as discussed above). Audio input device 1710 may include any device that generates a signal representative of a sound, such as microphones, microphone arrays, or digital instruments (e.g., instruments having a musical instrument digital interface (MIDI) output).

Computing device 1700 may include a global positioning system (GPS) device 1709 (or corresponding interface circuitry, as discussed above). GPS device 1709 may be in communication with a satellite-based system and may receive a location of computing device 1700.

Computing device 1700 may include another output device 1705 (or corresponding interface circuitry, as discussed above). Examples include an audio codec, a video codec, a printer, a wired or wireless transmitter for providing information to other devices, or an additional storage device.

Computing device 1700 may include another input device 1711 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1700 may include a security interface device 17012. Security interface device 1712 may include any device that provides security measures for computing device 1700 such as intrusion detection, biometric validation, security encode or decode, managing access lists, malware detection, or spyware detection.

Computing device 1700, or a subset of its components, may have any appropriate form factor, such as a server or other networked computing component, a mobile device, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that embodiments described herein may be practiced with modification and alteration without departing from the scope of the appended claims. For example, the above embodiments may include specific combinations of features as further provided below.

In first examples, an apparatus comprises a first electrode, a second electrode, and a composite insulator between the first electrode and the second electrode. The composite insulator including a plurality of hillocks comprising a compound of one or more metals and oxygen, and a filler between adjacent ones of the hillocks. The filler has a different composition or microstructure than the hillocks.

In second examples, for any of the first examples the filler comprises at least one of Al, Hf, or Zr.

In third examples, for any of the first through second examples wherein the compound of the one or more metals comprises at least one of Ti, Zr, or Hf.

In fourth examples, for any of the first through second examples the compound of the one or more metals is BTO, STO, or BSTO.

In fifth examples, for any of the fourth examples, wherein the filler comprises Al₂O₃.

In sixth examples, for any of the first through fifth examples wherein the hillocks are more crystalline than the filler.

In seventh examples, for any of the first through sixth examples the hillocks are predominantly in a first crystalline phase.

In eighth examples, for any of the seventh examples the hillocks comprise more rutile phase than the filler or the filler comprises more of a non-rutile phase than the hillocks.

In ninth examples, for any of the first through eighth example the filler is an amorphous compound.

In tenth examples, for any of the first through ninth examples the first electrode is in direct contact with a bottom of the hillocks, and the second electrode is in direct contact with a top of the hillocks as well as in direct contact with the filler.

In eleventh examples, for any of the tenth examples the first electrode is spaced apart from the filler by a non-zero thickness of the compound of the one or more metals and oxygen.

In twelfth examples, for any of the tenth through eleventh examples the filler at an interface of the second electrode has a lateral width of at least 20 nm.

In thirteenth examples, for any of the twelfth examples a thickness of the filler between two adjacent hillocks is at least 10 nm.

In fourteenth examples, for any of the first through thirteenth examples the first electrode comprises a metal or a semiconductor material and wherein the second electrode comprises a metal.

In fifteenth examples, an apparatus comprises a plurality of trenches in a substrate, a first electrode along a sidewall of individual ones of the trenches, and a first insulator in direct contact with the first electrode and lining the sidewall of individual ones of the trenches. The first insulator has a first thickness that varies along a depth of the sidewall from a minimum thickness to a first maximum thickness. The apparatus comprises a second insulator in direct contact with the first insulator and having a second thickness that varies over the depth of the sidewall from nil in first regions where the first thickness is at the first maximum thickness to a second maximum thickness in second regions where the first thickness is the minimum thickness. The apparatus comprises a second electrode lining the sidewall of individual ones of the trenches, the second electrode in direct contact with first insulator within the first regions and in direct contact with the second insulator within the second regions.

In sixteenth examples, for any of the fifteenth examples the first insulator comprises one or more metals and oxygen, and the second insulator has a different composition or microstructure than the first insulator.

In seventeenth examples, for any of the sixteenth examples the first insulator comprises Ti, Hf, or Zr and the second insulator also comprises one or more metals and oxygen.

In eighteenth examples, a method comprises depositing a first insulator upon a substrate, thermally annealing the insulator, depositing a second insulator within cracks in the first insulator and over a top surface of the first insulator, removing at least some the second insulator to expose the top surface of the first insulator, and forming a metal electrode over the first and second insulators.

In nineteenth examples, for any of the eighteenth examples depositing the first insulator comprises performing a first atomic layer deposition (ALD) process, depositing the second insulator comprises performing a second ALD process, and removing at least some the second insulator comprising performing an atomic layer etch (ALE) process.

In twentieth examples, for any of the nineteenth examples depositing the first insulator comprises depositing a compound of Ti, Hf, or Zr and depositing the second insulator comprises depositing a material of different composition or microstructure than the first insulator.

However, the above embodiments are not limited in this regard and, in various implementations, the above embodiments may include the undertaking of only a subset of such features, undertaking a different order of such features, undertaking a different combination of such features, and/or undertaking additional features than those features explicitly listed. The scope of the invention should, therefore, be determined with reference to the appended claims.

## Claims

1. An apparatus, comprising:
a first electrode;
a second electrode; and
a composite insulator between the first electrode and the second electrode, the composite insulator including a plurality of hillocks comprising a compound of one or more metals and oxygen, and a filler between adjacent ones of the hillocks, the filler having a different composition or microstructure than the hillocks.

2. The apparatus of claim 1, wherein the filler comprises at least one of Al, Hf, or Zr.

3. The apparatus of claim 1 or 2, wherein the compound of the one or more metals comprises at least one of Ti, Zr, or Hf.

4. The apparatus of claim 3, wherein the compound of the one or more metals is BTO, STO, or BSTO.

5. The apparatus of any one of claims 1-4, wherein the filler comprises Al₂O₃.

6. The apparatus of any one of claims 1-5, wherein the hillocks are more crystalline than the filler.

7. The apparatus of any one of claims 1-6, wherein the hillocks are predominantly in a first crystalline phase.

8. The apparatus of claim 7, wherein the hillocks comprise more rutile phase than the filler or the filler comprises more of a non-rutile phase than the hillocks.

9. The apparatus of any one of claims 1-8, wherein the filler is an amorphous compound.

10. The apparatus of any one of claims 1-9, wherein:
the first electrode is in direct contact with a bottom of the hillocks; and
the second electrode is in direct contact with a top of the hillocks as well as in direct contact with the filler.

11. The apparatus of any one of claims 1-10, wherein the first electrode is spaced apart from the filler by a non-zero thickness of the compound of the one or more metals and oxygen.

12. The apparatus of any one of claims 1-11, wherein:
the filler at an interface of the second electrode has a lateral width of at least 20 nm;
a thickness of the filler between two adjacent hillocks is at least 10 nm; and
the first electrode comprises a metal or a semiconductor material and wherein the second electrode comprises a metal.

13. An apparatus, comprising:
a plurality of trenches in a substrate;
a first electrode along a sidewall of individual ones of the trenches;
a first insulator in direct contact with the first electrode and lining the sidewall of individual ones of the trenches, the first insulator having a first thickness that varies along a depth of the sidewall from a minimum thickness to a first maximum thickness;
a second insulator in direct contact with the first insulator and having a second thickness that varies over the depth of the sidewall from nil in first regions where the first thickness is at the first maximum thickness to a second maximum thickness in second regions where the first thickness is the minimum thickness; and
a second electrode lining the sidewall of individual ones of the trenches, the second electrode in direct contact with first insulator within the first regions and in direct contact with the second insulator within the second regions.

14. The apparatus of claim 13, wherein the first insulator comprises one or more metals and oxygen, and the second insulator has a different composition or microstructure than the first insulator.

15. The apparatus of claim 14, wherein the first insulator comprises Ti, Hf, or Zr and wherein the second insulator also comprises one or more metals and oxygen.
